# EUROPÄISCHE PATENTSCHRIFT

(11) **EP 0 724 023 B1**
(45) Veröffentlichungstag und Bekanntmachung des Hinweises auf die Patenterteilung: **11.07.2001**
(21) Anmeldenummer: 96100905.7
(22) Anmeldetag: 23.01.1996
(51) Int. Cl.: C23C 14/06, C23C 30/00, C23C 14/32

(54) **Harte, amorphe, wasserstoffreie C-Schichten**
Hard, amorphous, hydrogen-free carbon films
Couches carbonées dures, amorphes et exemptes d'hydrogène

(30) Priorität: 27.01.1995 DE 19502568
(43) Veröffentlichungstag der Anmeldung: 31.07.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: Scheibe, Hans-Joachim Dr., 01277 Dresden (DE); Schultrich, Bernd, Dr.rer.nat.habil, D-01257 Dresden (DE)

(56) Entgegenhaltungen:
- WEAR (1990), 141(1), 45-58 CODEN: WEARAH;ISSN: 0043-1648, 1990, XP000570574 HIRVONEN, J. P. ET AL: "Characterization and unlubricated sliding of ion-beam-deposited hydrogen - free diamond - like carbon films"
- DIAMOND AND RELATED MATERIALS, Bd. 3, Nr. 11/12, 1.November 1994, Seiten 1319-1324, XP000483362 XIAO-MING HE ET AL: "STRUCTURAL CHARACTERIZATION AND PROPERTIES ENHANCEMENT OF DIAMOND-LIKE CARBON FILMS SYNTHESIZED UNDER LOW ENERGY NE+ BOMBARDMENT"
- NUCL. INSTRUM. METHODS PHYS. RES., SECT. B (1993), B80-81(PT. 2), 1502-6 CODEN: NIMBEU;ISSN: 0168-583X, 1993, XP000568031 LEMPERT, G. D. ET AL: "Tribological evaluation of hydrogen - free ion beam deposited diamondlike carbon coatings"
- THIN FILMS, PROC. JT. 4TH INT. SYMP. TRENDS NEW APPL. THIN FILMS 11TH CONF. HIGH VAC., INTERFACES THIN FILMS (1993), 353-6. EDITOR(S): HECHT, G.;RICHTER, F.; HAHN, J. PUBLISHER: DGM INFORMATIONSGES., OBERURSEL, GERMANY. CODEN: 60DAAP, 1993, XP000570625 KOLITSCH, A. ET AL: "Modification of laser-arc DLC layers by ion beams"
- THIN SOLID FILMS, Bd. 253, Nr. 1/02, 15.Dezember 1994, Seiten 125-129, XP000484036 SCHULTRICH B ET AL: "ELASTIC MODULUS OF DIAMOND-LIKE CARBON FILMS PREPARED BY PULSED VACUUM ARC"
- THIN SOLID FILMS, Bd. 212, Nr. 1 / 02, 15.Mai 1992, Seiten 216-219, XP000360217 DAVANLOO F ET AL: "MECHANICAL AND ADHESION PROPERTIES OF AMORPHIC DIAMOND FILMS"

## Beschreibung

Die Erfindung betrifft eine amorphe Kohlenstoffschicht, die sich durch einen Elastizitätsmodul (E-Modul oder Young's-Modul), der größer als 400 GPa ist, bzw. sich durch eine Härte, die größer als 40 GPa ist, auszeichnet, keinen Wasserstoff enthält und vorzugsweise zur Verringerung des Reibwertes bei Reibpaarungen unter reduziertem bzw. ohne Schmiermitteleinsatz eingesetzt werden kann.

Aus der DE 36 30 418 ist eine wasserstoffhaltige amorphe Kohlenstoffschicht, mit Zwischenschicht aus W, Cr, Ti, Si, Pa, Mo, bei Temperaturen 100°C-600°C, bevorzugt bei 300°C, bekannt und in der DE 41 27 639 werden Plasma CVD zur Herstellung von i-Carbon oder a-C:H-Schichten, die kein Metall enthalten, oder PVD-Verfahren, Sputtern oder Vakuumbogenverdampfung, wobei gleichzeitig Metalle verdampft und in die Schicht eingebaut werden, beschrieben, was eine partielle Carbidbildung zur Folge hat.

Diese im Stand der Technik beschriebenen Schichten weisen folgende Nachteile auf:
- relativ niedriger E-Modul in der Größenordnung der Nicht- oder Übergangsmetalle
- relativ niedrige Härte der amorphen Schichtmatrix
- härtere carbidische Einlagerungen wirken als abrasive Teilchen und können den Reibpartner verschleißen
- höhere Beschichtungstemperatur als 100°C, deshalb unökonomisch
- große Schichtdicke erforderlich, deshalb lange Beschichtungszeiten.

Darüber hinaus sind in Wear, 141 (1990) 45-58 wasserstofffreie, amorphe C-Schichten mit einer Dicke von 0,5 bis 10 µm, einer Härte von 75 GPa und einem Reibwert von 0.06 gemessen mit einem Si₃N₄-Stift, beschrieben.

Des weitern wurden in Diamond and Related Materials 3 (1994), 1319-24 amorphe Kohlenstoffschichten, die durch Zerstäubung eines Graphittargets mittels Argonionen hergestellt werden, beschrieben.

Der Erfindung liegt nunmehr die Aufgabe zugrunde, eine hochfeste, sehr harte Verschleißschutzschicht aus Kohlenstoff mit hoher Härte, bzw. hohem E-Modul zu schaffen, die sich als Gleitschicht für Reibpaarungen unter reduziertem, bzw. ohne Schmiermitteleinsatz verwenden lässt und dabei durch einen geringen Reibkoeffizienten eine hohe Abriebfestigkeit bei sich und den verwendeten Reibpartnern garantiert.

Diese Aufgabe wird nach der Erfindung gemäß einem oder mehreren der Ansprüche 1 bis 8 gelöst.

Erfindungsgemäß wird die Aufgabe dadurch gelöst, daß auf mindestens einer der Gleitflächen der Reibpaarung eine festhaftende, harte, amorphe, keinen Wasserstoff enthaltende Kohlenstoffschicht aus einem gepulsten, hochionisierten Kohlenstoff-Lichtbogenplasma im Vakuum abgeschieden wird, wobei dem Plasma keinerlei Wasserstoff oder Kohlenwasserstoff enthaltenden Komponenten zugeführt werden. Eine derartige Schicht ist gekennzeichnet durch einen Wasserstoffgehalt < 0,5 at.%, einen Elastizitätsmodul > 400 GPa, eine Härte > 40 GPa, eine Oberflächenrauheit im Bereich von ca. 100 nm. Sie kann Kohlenstoffteilchen enthalten, die überwiegend eine geringere Härte als die Schicht selbst besitzen. Dadurch werden einer derartigen Schicht selbstschmierende Eigenschaft verliehen. Die Dicke der Schichten beträgt günstigerweise mindestens 100 nm bis maximal einige µm (vorzugsweise 300 nm). Bereits bei einer Dicke > 100 nm sind diese Schichten dicht geschlossen und garantieren die gleichen Eigenschaften und Standzeiten wie Schichten, die einige um dick sind. Gegenüber wasserstoffenthaltenden amorphen Kohlenstoffschichten bzw. aus Metall-Kohlenstoff bestehenden Schichten, die durch chemisch reaktive Plasmaprozesse abgeschieden werden, zeichnen sich diese Schichten durch einen höheren E-Modul bzw. Härte, eine höhere mechanische, thermische und chemische Stabilität aus und garantieren eine höhere Standzeit bei Gleitreibungsprozessen durch einen verringerten Reibkoeffizienten.

Eine amorphe wasserstoffreie Kohlenstoffschicht kann durch lonenstrahlverfahren, durch gepulste Laserablation (Pulsed Laser Deposition / PLD) bzw. gepulste Bogenentladung im Vakuum aus einem graphitischen Target erzeugtem Ionen- bzw. Plasmastrahl abgeschieden werden, dem keinerlei wasserstoff- oder kohlenwasserstoffhaltige Komponenten zugeführt werden.

Von technischem Interesse sind dabei vor allem gepulste Bogenverfahren, da nur mit diesen technisch relevante Abscheideraten (> 200 nm/min) erzielbar sind. Vorzugsweise wird ein lasergesteuerter gepulster Vakuumbogen (LASER-ARC) verwendet. Beim Laser-arc wird mit einem Impulslaser der Bogen gezündet und gezielt über eine aus hochreinem Graphit bestehende, als Walze gestaltete, rotierende Kohlenstoffkathode (Target) geführt wird, was eine effektive und systematische Ausnutzung des Kathodenmaterials gewährleistet. Durch Verwendung von Stromimpulsen > 500 A und Variation der Bogenbrenndauer zwischen 10 und 100 µs kann sowohl die Materialmenge im Impuls, als auch die Struktur und somit die Eigenschaften der abgeschiedenen amorphen Schicht, bzw. die Erzeugung und der Einbau von Teilchen in die Schicht gezielt beeinflußt werden. Vorteilhaft ist, daß mit einer derartigen Quelle ein vollständig ionisiertes Plasma erzeugt wird und daß die Kohlenstoffionen überraschenderweise aus der Quelle (Kathoden-Anoden-Konfiguration) heraus eine ausreichende kinetische Energie erhalten, um die gewünschten Schichteigenschaften im Abscheideprozeß zu erzeugen. Dabei muß bei einfachster Anordnung keine zusätzliche Biasspannung an das Substrat angelegt werden.

Von entscheidender Bedeutung ist die Temperatur während des Abscheideprozesses. Extrem hohe E-Modul- bzw. Härtewerte werden erzielt, wenn die Temperatur am Substrat deutlich unterhalb von 100°C liegt und vorzugsweise die Raumtemperatur nicht übersteigt. Damit lassen sich derartige amorphe Kohlenstoffschichten besonders günstig auf temperaturempfindlichen Materialien, wie z.B. Schnellarbeitsstählen, Al-, Al-Legierungen, Messing, Bronze und insbesondere auf Kunststoffen aufbringen. Der LASER-ARC-Prozeß läßt sich problemlos durch Verwendung einer aus unterschiedlichsten Materialien, bzw. einer aus mehreren rotierenden Kathodenwalzen aus leitfähigen Materialien (z.B. Metallen) aufgebauten Plasmaquelle so gestalten, daß Zwischenschichten beliebiger Dicke zur Formierung des Grenzbereiches (Interface) zwischen dem Bauteil und der amorphen Kohlenstoffschicht eingefügt werden können. Ebenso können Mehrfachschichtsysteme (Multilayer) abgeschieden werden, wobei eine Komponente stets aus amorphen, wasserstoffreiem Kohlenstoff besteht.

Durch Variation von Prozeßparametern (Beschichtungstemperatur, Bias-Spannung, Auftreffwinkel der C-lonen auf dem Bauteil) kann z.B. ein Gradient der Härte bzw. des E-Moduls in der Schicht erzeugt werden. Dieser Gradient der Schicht bzw. Wechselschicht ist dergestalt, daß die Härte bzw. das E-Modul von der Substrat- zur Außenseite zunimmt.

Die erfindungsgemäßen Schichten haben eine geringe Rauheit, die ≲ 100 nm ist, eine hohe termische Stabilität bis zu Temperaturen von 600°C und eine hohe Beständigkeit gegenüber sauren und alkalischen Chemikalien. Diese Schichten können Teilchen im Bereich von einigen 10 bis 100 nm Größe enthalten, die sich überwiegend durch eine geringere Härte als die Schicht selbst auszeichnen. Dadurch werden derartigen Schichten selbstschmierende Eigenschaften verliehen. Durch den hohen Elastizitätsmodul und die hohe Härte besitzen diese amorphen Schichten bereits bei einer Dicke von einigen 100 nm eine hohe mechanische Stabilität und können nur von solchen Materialien wie Diamant oder kubischem Bornitrid verletzt werden. Aufgrund der geringen Oberflächenrauheit werden bei dem als Gleitflächenmaterial eingesetzten Reibpartner keine Verschleißerscheingungen hervorgerufen, so daß eine Reibpaarung von höchster Stabilität erhalten wird.

Die erfindungsgemäßen Schichten werden in nachfolgenden Ausführungsbeispielen näher erläutert.

### Ausführungsbeispiel 1

Ein aus einer Al-Legierung bestehendes rotationssymmetrisches Bauteil mit einer Oberflächenrauheit < 1,0 µm wird nach üblicher chemischer Vorreinigung und Trocknung in einer Vakuumkammer auf einem rotierenden Substrathalter montiert. Nach einem 10-minütigen Glimmprozeß unter Argon (Druck 6 Pa) bei dem die Beschleunigungsspannung so gewählt ist, daß die mittlere Substrattemperatur 100°C nicht überschreitet, wird mittels einer Kyropumpe ein Vakuum von 10⁻⁴ Pa erzeugt und mit dem lasergesteuerten gepulsten Vakuumbogen in 5 Minuten eine homogene 300 nm dicke amorphe Kohlenstoffschicht auf der zylindrischen äußeren Mantelfläche aufgebracht. Dabei wird am Substrat die Temperatur von 80°C nicht überschritten. Nach Ausbau des Bauteils aus der Kammer, wird zerstörungsfrei mittels Ultraschall-Oberflächenwellen-Messung ein E-Modul von 450 GPa bestimmt, wodurch auf eine Härte von ca. 40 GPa geschlossen werden kann.

Dieses Bauteil wurde als Prüfkörper im Amsler-Reibtest eingesetzt, wobei ein reduzierter Schmiermitteleinsatz erfolgte. Als Gegenkörper wurde ein Graugußklotz mit einer Kraft von 200 N angepreßt und der Reibwert, das Reibmoment und die Temperatur am Bauteil während des gesamten Versuchszyklus, ca. 5.000 km Laufleistung, gemessen. Nach kurzer Einlaufphase stellt sich ein Reibwert von 0.01 bei einer leicht erhöhten Temperatur von 24°C ein. Mittels AFM-Untersuchung konnten keinerlei Veränderungen an der Schichtoberfläche nach dem Verschleißtest nachgewiesen werden.

### Ausführungsbeispiel 2

Ein aus einem Stahl bestehendes rotationssymmetrisches Bauteil mit einer Oberflächenrauheit < 1,0 um wird nach üblicher chemischer Vorreinigung und Trocknung in einer Vakuumkammer auf einem rotierenden Substrathalter montiert. Nach einem 10-minütigen Glimmprozeß unter Argon (Druck 6 Pa) bei dem die Beschleunigungsspannung so gewählt ist, daß die mittlere Substrattemperatur 100°C nicht überschreitet, wird mittels einer Kyropumpe ein Vakuum von 10⁻⁴ Pa erzeugt. Mit dem lasergesteuerten gepulsten Vakuumbogen, bei dem eine aus Graphit und Aluminium bestehende Kathodenwalze verwendet wird, wird zunächst eine ca. 20 nm dicke Al-Schicht und anschließend in 5 Minuten eine homogene 300 nm dicke amorphe Kohlenstoffschicht auf der zylindrischen äußeren Mantelfläche aufgebracht. Dabei wird am Substrat die Temperatur von 80°C nicht überschritten. Nach Ausbau des Bauteils aus der Kammer, wird zerstörungsfrei mittels Ultraschall-Oberflächenwellen-Messung ein E-Modul von 480 GPa bestimmt, wobei aus dieser Messung auf eine Schichthärte von ca. 40 GPa geschlossen werden kann. Dieses Bauteil wurde als Prüfkörper im Amsler-Reibtest eingesetzt, wobei ein reduzierter Schmiermitteleinsatz erfolgte. Als Gegenkörper wurde ein Graugußklotz mit einer Kraft von 200 N angepreßt und der Reibwert, das Reibmoment und die Temperatur am Bauteil während des gesamten Versuchszyklus, ca. 5.000 km Laufleistung, gemessen. Nach kurzer Einlaufphase stellt sich ein Reibwert von 0.01 bei einer leicht erhöhten Temperatur von 24°C ein. Mittels AFM-Untersuchung konnten keinerlei Veränderungen an der Schichtoberfläche nach dem Verschleißtest nachgewiesen werden.

## Patentansprüche

1. Harte, dünne, amorphe Kohlenstoffschicht, die sich durch eine glatte, gleichmäßige Oberflächenmorphologie auszeichnet, bestehend aus reinem Kohlenstoff mit weniger als 0,5 at% Komponenten eines Metalls und/oder Wasserstoff, die mittels gepulster Lichtbogenentladung im Vakuum (Vakuumbogen), vorzugsweise lasergesteuerten, gepulsten Vakuumbogen (Laser-Arc), hergestellt ist, **dadurch gekennzeichnet,** dass diese Schicht einen mittels Ultraschalloberflächenwellen gemessenen Elastizitätsmodul größer 400 GPa aufweist, die ein ausgezeichnetes Reib-Gleit-Verhalten besitzt, welches durch einen Reibwert kleiner 0,1 ohne Schmiermitteleinsatz bzw. durch einen Reibwert kleiner 0,02 bei reduziertem Schmiermitteleinsatz besitzt und die eine hohe Beständigkeit gegen abrasiven Verschleiß und eine hohe chemische Beständigkeit zeigt.

2. Schicht nach Anspruch 1, **dadurch gekennzeichnet,** dass sie eine Härte grösser 40 GPa aufweist, wobei die Schicht Kohlenstoffteilchen mit einer überwiegend geringeren Härte als die Schicht enthalten kann.

3. Schicht nach Anspruch 1 oder 2, **dadurch gekennzeichnet,** dass diese Schicht eine Dicke von mindestens 100 nm und maximal einigen wenigen um aufweist.

4. Schicht nach Anspruch 3, **dadurch gekennzeichnet,** dass diese Schicht eine Dicke von 300 nm aufweist.

5. Schicht nach einem oder mehreren der Ansprüche 1 bis 4, **dadurch gekennzeichnet,** dass sie im Wechsel mit einem Metall als Wechselschicht mit Metall (Metall-Kohenstoff-Multilayer) mit dem Laser-Arc abgeschieden ist.

6. Schicht nach einem oder mehreren der Ansprüche 1 bis 5, **dadurch gekennzeichnet,** dass diese Schicht bzw. Wechselschicht einen Gradient der Härte bzw. des E-Moduls enthält.

7. Schicht nach Anspruch 6, **dadurch gekennzeichnet,** dass die Härte bzw. das E-Modul der Schicht bzw. der Wechselschicht von der auf dem Substrat haftenden Seite zur Außenseite bzw. der äußeren Deckschicht zunimmt.

8. Schicht nach einem oder mehreren der Ansprüche 1 bis 7, **dadurch gekennzeichnet,** dass diese Schicht optisch transparent ist.

## Claims

1. Hard, thin, amorphous carbon layer, which is distinguished by a smooth, uniform surface morphology, made of pure carbon having less than 0.5% at. constituents of a metal and/or hydrogen, which layer is produced by means of pulsed arc discharge in a vacuum (vacuum arc), preferably a laser-controlled, pulsed vacuum arc (laser arc), **characterised in that** this layer has a modulus of elasticity, which is measured by means of ultrasound surface waves and is greater than 400 GPa, which layer possesses an excellent sliding friction behaviour, which has a coefficient of friction less than 0.1 without lubricant usage or a coefficient of friction less than 0.02 with reduced lubricant usage and which layer shows high resistance against abrasive wear and a high chemical resistance.

2. Layer according to claim 1, **characterised in that** it possesses a hardness greater than 40 GPa, the layer being able to contain carbon particles with a hardness predominantly less than the layer.

3. Layer according to claim 1 or 2, **characterised in that** this layer has a thickness of at least 100 nm and a maximum of a few µm.

4. Layer according to claim 3, **characterised in that** this layer has a thickness of 300 nm.

5. Layer according to one or more of the claims 1 to 4, **characterised in that** it is deposited alternately with metal (metal carbon multilayer) by the laser arc, having a metal as alternate layer.

6. Layer according to one or more of the claims 1 to 5, **characterised in that** this layer or alternate layer contains a gradient of the hardness or of the elastic modulus.

7. Layer according to claim 6, **characterised in that** the hardness or the elastic modulus of the layer or of the alternate layer increases from the side adhering to the substrate towards the exterior side or the exterior cover layer.

8. Layer according to one or more of the claims 1 to 7, **characterised in that** this layer is optically transparent.

## Revendications

1. Couche mince, dure, de carbone amorphe, qui se distingue par une morphologie de surface lisse, uniforme, constituée de carbone pur avec moins de 0,5 % en atomes de composants d'un métal et/ou d'hydrogène, qui est obtenue par décharge luminescente en arc pulsé sous vide (arc sous vide), de préférence arc sous vide pulsé guidé par laser (arc laser),
caractérisée en ce que
cette couche présente un module d'élasticité, mesuré à l'aide d'ondes superficielles ultrasoniques, de plus de 400 GPa, présente un excellent comportement de glissement-frottement, présente un coefficient de frottement inférieur à 0,1 sans addition de lubrifiant ou un coefficient de frottement inférieur à 0,02 avec une utilisation réduite de lubrifiant, et manifeste une haute résistance à l'usure abrasivé et une haute résistance aux agents chimiques.

2. Couche selon la revendication 1,
caractérisée en ce qu'
elle présente une dureté supérieure à 40 GPa, la couche pouvant contenir des particules de carbone ayant une dureté nettement plus faible que celle de la couche.

3. Couche selon la revendication 1 ou 2,
caractérisée en ce que
cette couche présente une épaisseur d'au moins 100 nm et au maximum de quelques µm.

4. Couche selon la revendication 3,
caractérisée en ce que
cette couche présente une épaisseur de 300 nm.

5. Couche selon l'une quelconque des revendications 1 à 4,
caractérisée en ce qu'
elle est déposée en alternance avec un métal en tant que couche alterne, avec un métal (multicouche carbone-métal) à l'aide de l'arc à laser.

6. Couche selon l'une quelconque des revendications 1 à 5,
caractérisée en ce que
cette couche ou couche alternée comporte un gradient de la dureté ou du module d'élasticité.

7. Couche selon la revendication 6,
caractérisée en ce que
la dureté ou le module d'élasticité de la couche ou de la couche alternée augmente de la face adhérant au substrat à la face extérieure ou à la couche extérieure de recouvrement.

8. Couche selon l'une quelconque des revendications 1 à 7,
caractérisée en ce que
cette couche est transparente optiquement.
